# EUROPEAN PATENT APPLICATION

(11) **EP 4 224 645 A1**
(43) Date of publication of application: **09.08.2023**
(21) Application number: 21885052.7
(22) Date of filing: 22.10.2021
(51) Int. Cl.: H01S 5/12, H01S 5/34

(54) **LASER MANUFACTURING METHOD AND LASER**

(30) Priority: 26.10.2020 CN 202011158751
(71) Applicant: Zhongxing Photonics Technology Co., Ltd., Nanjing, Jiangsu 210012 (CN)
(72) Inventor: DENG, Qiufang, Nanjing, Jiangsu 210012 (CN)
(74) Representative: Zoli, Filippo
(86) International application number: PCT/CN2021/125767
(87) International publication number: WO 2022/089325

(57) **Abstract**

A laser manufacturing method and a laser. The manufacturing method comprises: sequentially dividing a first distributed feedback (DFB) area, a turning area, and a second DFB area on a substrate (110); respectively preparing a selective medium mask strip pair in the first DFB area and the second DFB area (120), or preparing a selective medium mask strip pair in the turning area; sequentially epitaxially growing a bottom separate confinement layer, a multi-quantum well layer, and a top separate confinement layer in the first DFB area in which the selective medium mask strip pair is prepared, the turning area, and the second DFB area in which the selective medium mask strip pair is prepared, or in the first DFB area, the turning area in which the selective medium mask strip pair is prepared, and the second DFB area, so that the compositions of the multi-quantum well layer of the turning area respectively deviate from the compositions of the multi-quantum well layers of the first DFB area and the second DFB area; and removing the selective medium mask strip pairs (140).

## Description

### CROSS-REFERENCE TO RELATED APPLICATION

This application is filed on the basis of Chinese patent application 202011158751.8 filed October 26, 2020, and claims priority to the Chinese patent application, the entire contents of which are incorporated herein by reference.

### TECHNICAL FIELD

Embodiments of the present disclosure relate to, but not limited to, the field of communication, in particular to a manufacturing method for a laser, and a laser.

### BACKGROUND

In recent years, with the rapid increase in the amount of information transmitted in the field of optical communication, Wavelength Division Multiplexing (WDM) systems capable of effectively expanding the communication capacity have been developed rapidly, and wavelength tunable semiconductor lasers that can be used to build more effective communication systems have attracted wide attention. Semiconductor lasers with good wavelength stability, wide wavelength tuning range, compact structure, low power consumption and high-speed operation are of great significance in the field of optical communication.

At present, tunable semiconductor lasers mainly include Distributed Bragg Reflection (DBR) lasers and Distributed Feedback (DFB) lasers. For a tunable integrated DFB laser with a compact structure, although a lasing wavelength can be changed by injecting a current into a phase region, because an intermediate phase region is made of butt-joint growth bulk material (excluding a grating), and an initial phase of a grating end face in each of DFB areas at two sides is determined by the shape of the grating, mode hopping is likely to occur, and unsatisfactory shape repeatability leads to a great change in the lasing wavelength. In addition, a butt-joint interface between the phase regions may produce crystal defects, thereby reducing the reliability of the laser.

### SUMMARY

A main object of embodiments of the present disclosure is to provide a manufacturing method for a laser, and a laser.

In accordance with a first aspect of the present disclosure, an embodiment provides a manufacturing method for a laser. The method includes: sequentially dividing a first Distributed Feedback (DFB) area, a tuning area and a second DFB area on a substrate; preparing a selective area growth mask strip pair in each of the first DFB area and the second DFB area; sequentially epitaxially growing a lower separate confinement heterostructure layer, a multi-quantum well layer and an upper separate confinement heterostructure layer in the first DFB area in which the selective area growth mask strip pair is prepared, the tuning area, and the second DFB area in which the selective area growth mask strip pair is prepared, such that the compositions of the multi-quantum well layer of the tuning area deviate from the compositions of the multi-quantum well layer of each of the first DFB area and the second DFB area; and removing the selective area growth mask strip pair.

In accordance with a second aspect of the present disclosure, an embodiment provides a manufacturing method for a laser. The method includes: sequentially dividing a first DFB area, a tuning area and a second DFB area on a substrate; preparing a selective area growth mask strip pair in the tuning area; sequentially epitaxially growing a lower separate confinement heterostructure layer, a multi-quantum well layer and an upper separate confinement heterostructure layer in the first DFB area, the tuning area in which the selective area growth mask strip pair is prepared, and the second DFB area, such that the compositions of the multi-quantum well layer of the tuning area deviate from the compositions of the multi-quantum well layer of each of the first DFB area and the second DFB area; and removing the selective area growth mask strip pair.

In accordance with a third aspect of the present disclosure, an embodiment further provides a laser. The laser is manufactured by means of the manufacturing method described in the first aspect, or the laser is manufactured by means of the manufacturing method described in the second aspect.

### BRIEF DESCRIPTION OF DRAWINGS

Fig. 1 is a flowchart of a manufacturing method for a laser provided in an embodiment of the present disclosure;
Fig. 2 is a flowchart of a manufacturing method for a laser provided in another embodiment of the present disclosure;
Fig. 3 is a flowchart of a manufacturing method for a laser provided in yet another embodiment of the present disclosure;
Fig. 4 is a flowchart of a manufacturing method for a laser provided in yet another embodiment of the present disclosure;
Fig. 5 is a flowchart of a manufacturing method for a laser provided in yet another embodiment of the present disclosure;
Fig. 6 is a flowchart of a manufacturing method for a laser provided in yet another embodiment of the present disclosure;
Fig. 7 is a top view of a laser provided in an embodiment of the present disclosure;
Fig. 8 is a top view of a laser provided in another embodiment of the present disclosure;
Fig. 9 is a first schematic diagram of a manufacturing process of a laser according to a first embodiment of the present disclosure;
Fig. 10 is a second schematic diagram of a manufacturing process of a laser according to a first embodiment of the present disclosure;
Fig. 11 is a third schematic diagram of a manufacturing process of a laser according to a first embodiment of the present disclosure;
Fig. 12 is a fourth schematic diagram of a manufacturing process of a laser according to a first embodiment of the present disclosure;
Fig. 13 is a fifth schematic diagram of a manufacturing process of a laser according to a first embodiment of the present disclosure;
Fig. 14 is a top view of a laser according to a second embodiment of the present disclosure; and
Fig. 15 is a schematic diagram of a manufacturing process of a laser according to a third embodiment of the present disclosure.

### DETAILED DESCRIPTION

In order to make the objects, technical schemes and advantages of the present disclosure clear, the present disclosure will be further described in detail in conjunction with the drawings and embodiments. It should be understood that the specific embodiments described here are only used to illustrate the present disclosure, and are not intended to limit the present disclosure.

It is to be noted, although functional modules have been divided in the schematic diagrams of apparatuses and logical orders have been shown in the flowcharts, in some cases, the modules may be divided in a different manner, or the steps shown or described may be executed in an order different from the orders as shown in the flowcharts.

This embodiment provides a manufacturing method for a laser, and a laser. The manufacturing method for a laser includes: sequentially dividing a first Distributed Feedback (DFB) area, a tuning area and a second DFB area on a substrate; preparing a selective area growth mask strip pair in each of the first DFB area and the second DFB area, or preparing a selective area growth mask strip pair in the tuning area; sequentially epitaxially growing a lower separate confinement heterostructure layer, a multi-quantum well layer and an upper separate confinement heterostructure layer in the first DFB area in which the selective area growth mask strip pair is prepared, the tuning area, and the second DFB area in which the selective area growth mask strip pair is prepared, or in the first DFB area, the tuning area in which the selective area growth mask strip pair is prepared, and the second DFB area, such that the compositions of the multi-quantum well layer of the tuning area deviate from the compositions of the multi-quantum well layer of each of the first DFB area and the second DFB area; and removing the selective area growth mask strip pair. In the manufacturing method, the laser is divided into a first DFB area, a tuning area and a second DFB area, a selective area growth mask strip pair is prepared before the lower separate confinement heterostructure layer is grown, such that the compositions of the multi-quantum well layer of the tuning area deviate from the compositions of the multi-quantum well layer of each of the first DFB area and the second DFB area, and the selective area growth mask strip pair is removed after the upper separate confinement heterostructure layer is grown. The laser manufactured by means of the manufacturing method has high reliability and an increased wavelength tuning range.

The embodiments of the present disclosure will be further illustrated in conjunction with the drawings.

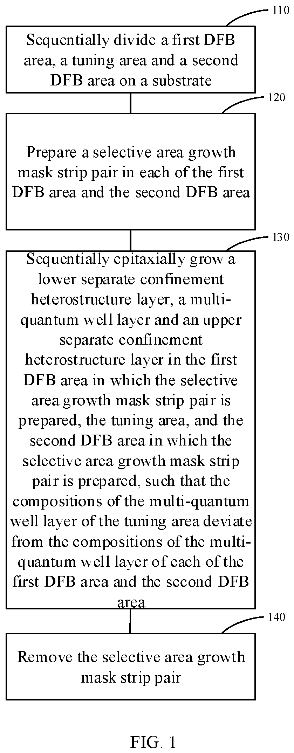

Fig. 1 is a flowchart of a manufacturing method for a laser provided in an embodiment of the present disclosure. In an embodiment, the manufacturing method for a laser includes, but not limited to, following steps S110 to S140.

At S110, a first DFB area, a tuning area and a second DFB area are sequentially divided on a substrate.

In an embodiment, a first DFB area, a tuning area and a second DFB area may be sequentially divided on an epitaxially grown plane of a substrate, and the epitaxial growth based on the substrate is performed according to the divided three areas in a manufacturing process of the laser.

At S120, a selective area growth mask strip pair is prepared in each of the first DFB area and the second DFB area.

In an embodiment, a selective area growth mask strip pair may be prepared in each of the first DFB area and the second DFB area before epitaxially growing a lower separate confinement heterostructure layer.

It should be noted that the strip width, spacing and shape of prepared selective area growth mask strips are set according to the requirements of the laser to be manufactured, which will not be specifically limited in this embodiment.

In an embodiment, a first selective area growth mask strip pair may be prepared in the first DFB area, and includes a first selective area growth mask strip and a second selective area growth mask strip which are sequentially arranged in a first direction. A second selective area growth mask strip pair may be prepared in the second DFB area, and includes a third selective area growth mask strip and a fourth selective area growth mask strip which are sequentially arranged in the first direction. The first selective area growth mask strip pair and the second selective area growth mask strip pair may be prepared in a second direction perpendicular to the first direction.

For example, the first selective area growth mask strip pair may be prepared in the first DFB area, and include two cuboids which have identical size and shape and are arranged in parallel in the first direction. The second selective area growth mask strip pair may be prepared in the second DFB area, and include two cuboids which have identical strip width and shape, are spaced apart, and are arranged in parallel in the first direction. The first selective area growth mask strip pair and the second selective area growth mask strip pair are arranged in a second direction.

In an embodiment, based on the above embodiment, the first selective area growth mask strip and the third selective area growth mask strip may be arranged in mirror symmetry; and the second selective area growth mask strip and the fourth selective area growth mask strip may be arranged in mirror symmetry.

It should be noted that the first selective area growth mask strip pair and the second selective area growth mask strip pair may be arranged in mirror symmetry, which will not be specifically limited in this embodiment.

In an embodiment, based on the above embodiment, an end of each of the first selective area growth mask strip, the second selective area growth mask strip, the third selective area growth mask strip and the fourth selective area growth mask strip close to the tuning area may be prepared in a gradually narrowed shape. After epitaxial material growth, an interface between the DFB area and the tuning area transitions smoothly, which can reduce the possibility of interface defects and avoid the reliability problems caused by interface defects.

For example, the end of each of the first selective area growth mask strip, the second selective area growth mask strip, the third selective area growth mask strip and the fourth selective area growth mask strip close to the tuning area may be prepared in a shape of a right triangle.

It should be noted that the selective area growth mask strip pair may be made of silicon dioxide or silicon oxynitride, which will not be specifically limited in this embodiment.

At S130, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair is prepared, such that the compositions of the multi-quantum well layer of the tuning area deviate from the compositions of the multi-quantum well layers of each of the first DFB area and the second DFB area.

In an embodiment, after the selective area growth mask strip pair is prepared, a lower separate confinement heterostructure layer, a multi-quantum well layer and an upper separate confinement heterostructure layer may be sequentially epitaxially grown in the first DFB area in which the selective area growth mask strip pair is prepared, the tuning area, and the second DFB area in which the selective area growth mask strip pair is prepared. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to a large area (that is, an area not corresponding to the selective area growth mask strip pair). Therefore, only one epitaxial growth is needed to realize the deviation of band gap wavelengths of active layers of the tuning area and the DFB areas (including the first DFB area and the second DFB area), thereby realizing that a boundary current of the tuning area is greater than a threshold current of the DFB areas, and thus increasing a wavelength tuning range of the laser.

At S140, the selective area growth mask strip pair is removed.

In an embodiment, after the growth of the upper separate confinement heterostructure layer is completed, that is, after the material compositions of the area corresponding to the selective area growth mask strip pair have changed, the selective area growth mask strip pair can be removed, and then epitaxial growth can be continued.

It should be noted that the process of removing the selective area growth mask strip pair may be performed by means of wet etching or dry etching, which will not be specifically limited in this embodiment.

In an embodiment, with the above steps S 110 to S 140, a first DFB area, a tuning area and a second DFB area are sequentially divided on an epitaxially grown plane of a substrate; a selective area growth mask strip pair is prepared in each of the first DFB area and the second DFB area; after the selective area growth mask strip pair is prepared, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair is prepared; and the selective area growth mask strip pair is removed. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design of the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The overall manufacturing method for a laser is simple, only the preparation of the selective area growth mask strip pair is added, and the manufacturing cost of the laser can be well controlled.

It should be noted that after the selective area growth mask stripe pair is removed, epitaxial growth can be continued on the upper separate confinement heterostructure layer, and electrodes can be set after the growth is completed, to complete the manufacture of the laser. The number and type of layers to be continuously grown are not specifically limited in this embodiment. For example, a cover layer and a contact layer are continuously epitaxially grown on the upper separate confinement heterostructure layer, then preparation is performed by adopting a general semiconductor laser process to complete the subsequent process, and electrical isolation between the DFB areas and the wavelength tuning area is realized by adopting groove etching or ion implantation.

It should be noted that a material system for manufacturing the laser may be an indium gallium arsenic phosphorus/indium phosphide material system, or an indium gallium arsenic aluminum/indium phosphide material system, which will not be specifically limited in this embodiment.

It should be noted that the stripe width, spacing and shape of the selective area growth mask stripe pair can be determined according to actual manufacturing situations, which will not be specifically limited in this embodiment.

It should be noted that, by setting the stripe width, spacing and shape of the selective area growth mask strip pair, a material gain peak in the tuning area of the laser may deviate from a material gain peak in each DFB area by 30-80 nm. If an amount of deviation of the gain peaks is too large, the material growth quality is affected, and the transition interface is not smooth enough, affecting the reliability of the laser; and if the amount of deviation of the gain peaks is too small, an amount of deviation of a Bragg lasing wavelength from a PL peak wavelength of the tuning area is too small, and a difference between the boundary current of the active layer of the tuning area and the threshold current of the active layers of the two DFB areas is small, thus the tuning range of the laser cannot be effectively increased.

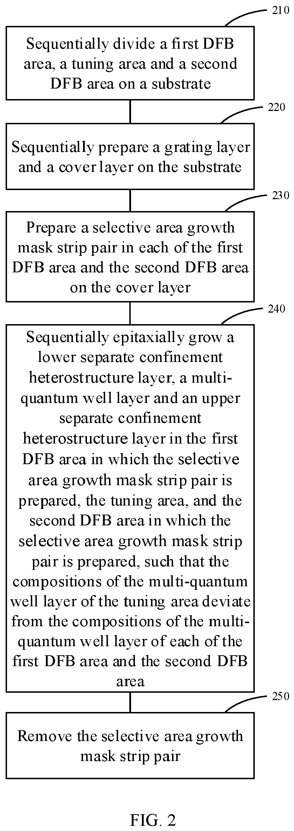

Referring to Fig. 2, in an embodiment, the manufacturing method for a laser according to the embodiment in Fig. 1 is expanded, and includes, but not limited to, following steps S210 to S250.

At S210, a first DFB area, a tuning area and a second DFB area are sequentially divided on a substrate.

At S220, a grating layer and a cover layer are sequentially prepared on the substrate.

At S230, a selective area growth mask strip pair is prepared in each of the first DFB area and the second DFB area on the cover layer.

At S240, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair is prepared, such that the compositions of the multi-quantum well layer of the tuning area deviate from the compositions of the multi-quantum well layer of each of the first DFB area and the second DFB area.

At S250, the selective area growth mask strip pair is removed.

In an embodiment, with the steps S210 to S250, a first DFB area, a tuning area and a second DFB area are sequentially divided on an epitaxially grown plane of a substrate; a grating layer and a cover layer are sequentially prepared on the substrate; a selective area growth mask strip pair is prepared in each of the first DFB area and the second DFB area of the cover layer; after the selective area growth mask strip pair is prepared, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair is prepared; and the selective area growth mask strip pair is removed. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design of the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The overall manufacturing method for a laser is simple, only the preparation of the selective area growth mask strip pair is added, and the manufacturing cost of the laser can be well controlled.

It should be noted that a grating of the grating layer may have a period of Λ, and a Bragg lasing wavelength of the laser is expressed as λ=2neffΛ, where neff is an effective refractive index of a waveguide, and A is the period of the grating. The lasing wavelength determined by the period A of the grating and the effective refractive index neff jointly is designed to be at the apex of the gain peak of the active layers of the two DFB areas, so that the gain peak of the active layer of the tuning area has a certain amount of deviation from the Bragg lasing wavelength, thereby increasing the boundary current of the tuning area.

It should be noted that the grating may be prepared by means of holographic exposure or electron beam direct writing, which will not be specifically limited in this embodiment.

It should be noted that the grating may be a uniform grating or a phase shift grating, which will not be specifically limited in this embodiment.

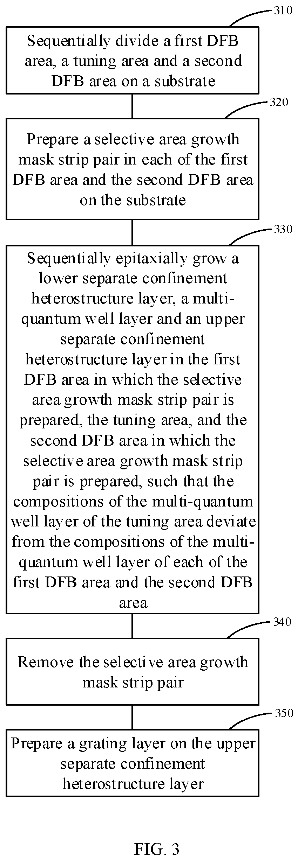

Referring to Fig. 3, in an embodiment, the manufacturing method for a laser according to the embodiment in Fig. 1 is expanded, and include, but not limited to, following steps S310 to S350.

At S310, a first DFB area, a tuning area and a second DFB area are sequentially divided on a substrate.

At S320, a selective area growth mask strip pair is prepared in each of the first DFB area and the second DFB area on the substrate.

At S330, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair is prepared, such that the compositions of the multi-quantum well layer of the tuning area deviate from the compositions of the multi-quantum well layer of each of the first DFB area and the second DFB area.

At S340, the selective area growth mask strip pair is removed.

At S350, a grating layer is prepared on the upper separate confinement heterostructure layer.

In an embodiment, with the above steps S310 to S350, a first DFB area, a tuning area and a second DFB area are sequentially divided on an epitaxially grown plane of a substrate; a selective area growth mask strip pair is prepared in each of the first DFB area and the second DFB area on the substrate; after the selective area growth mask strip pair is prepared, a lower separate confinement heterostructure layer, a multi-quantum well layer and an upper separate confinement heterostructure layer are sequentially epitaxially grown in the first DFB area in which the selective area growth mask strip pair is prepared, the tuning area, and the second DFB area in which the selective area growth mask strip pair; the selective area growth mask strip pair is removed; and a grating is prepared on the upper separate confinement heterostructure layer. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design of the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The manufacturing method for a laser is simple, only the preparation of the selective area growth mask strip pair is added, and the manufacturing cost of the laser can be well controlled.

It should be noted that preparing a grating layer on the upper separate confinement heterostructure layer may be directly preparing a grating on the upper separate confinement heterostructure layer, or growing a grating layer on the upper separate confinement heterostructure layer and preparing a grating on the grating layer.

It should be noted that the grating of the grating layer may have a period of Λ, and a Bragg lasing wavelength of the laser is expressed as λ=2neffΛ, where neff is an effective refractive index of a waveguide, and A is the period of the grating. The lasing wavelength determined by the period A of the grating and the effective refractive index neff jointly is designed to be at the apex of the gain peak of the active layers of the two DFB areas, so that the gain peak of the active layer of the tuning area has a certain amount of deviation from the Bragg lasing wavelength, thereby increasing the boundary current of the tuning area.

It should be noted that the grating may be prepared by means of holographic exposure or electron beam direct writing, which will not be specifically limited in this embodiment.

It should be noted that the grating may be a uniform grating or a phase shift grating, which will not be specifically limited in this embodiment.

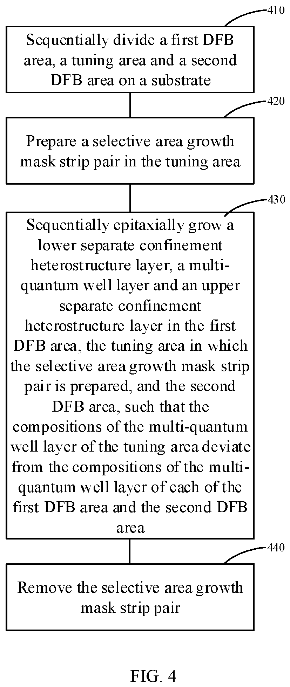

Referring to Fig. 4, in an embodiment, the manufacturing method for a laser includes, but not limited to, following steps S410 to S440.

At S410, a first DFB area, a tuning area and a second DFB area are sequentially divided on a substrate.

At S420, a selective area growth mask strip pair is prepared in the tuning area.

In an embodiment, the prepared selective area growth mask strip pair may include two cuboids which have identical strip width and shape, are spaced apart and are arranged in parallel.

In an embodiment, an end of the selective area growth mask strip pair close to the first DFB area is prepared in a gradually narrowed shape; and the end of the selective area growth mask strip pair close to the second DFB area is prepared in a gradually narrowed shape. After epitaxial material growth, an interface between the DFB areas and the tuning area transitions smoothly, which can reduce the possibility of interface defects and avoid the reliability problems caused by interface defects.

It should be noted that the strip width, spacing and shape of prepared selective area growth mask strips are set according to the requirements of the laser to be manufactured, which will not be specifically limited in this embodiment.

At S430, a lower separate confinement heterostructure layer, a multi-quantum well layer and an upper separate confinement heterostructure layer are sequentially epitaxially grown in the first DFB area, the tuning area in which the selective area growth mask strip pair is prepared, and the second DFB area, such that the compositions of the multi-quantum well layer of the tuning area deviate from the compositions of the multi-quantum well layer of each of the first DFB area and the second DFB area.

At S440, the selective area growth mask strip pair is removed.

In an embodiment, with the above steps S410 to S440, a first DFB area, a tuning area and a second DFB area are sequentially divided on an epitaxially grown plane of a substrate; a selective area growth mask strip pair is prepared in the tuning area; after the selective area growth mask strip pair is prepared, a lower separate confinement heterostructure layer, a multi-quantum well layer and an upper separate confinement heterostructure layer are sequentially epitaxially grown in the first DFB area, the tuning area in which the selective area growth mask strip pair is prepared, and the second DFB area; and the selective area growth mask strip pair is removed. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The overall manufacturing method for a laser is simple, only the preparation of the selective area growth mask strip pair is added, and the manufacturing cost of the laser can be well controlled.

It should be noted that after the selective area growth mask stripe pair is removed, growth can be continued on the upper separate confinement heterostructure layer, and electrodes can be set after the growth is completed, to complete the manufacture of the laser. The number and type of layers to be continuously grown are not specifically limited in this embodiment.

It should be noted that a material system for manufacturing the laser may be an indium gallium arsenic phosphorus/indium phosphide material system, or an indium gallium aluminum arsenic/indium phosphide material system, which will not be specifically limited in this embodiment.

It should be noted that the stripe width, spacing and shape of the selective area growth mask stripe pair can be determined according to actual manufacturing situations, which will not be specifically limited in this embodiment.

It should be noted that, by setting the stripe width, spacing and shape of the selective area growth mask strip pair, a material gain peak in the tuning area of the laser may deviate from a material gain peak in each DFB area by 30-80 nm. If an amount of deviation of the gain peaks is too large, the material growth quality is affected, and the transitioned interface is not smooth enough, affecting the reliability of the laser; and if the amount of deviation of the gain peaks is too small, an amount of deviation of a Bragg lasing wavelength from a PL peak wavelength of the tuning area is too small, and a difference between the boundary current of the active layer of the tuning area and the threshold current of the active layers of the two DFB areas is small, thus the tuning range of the laser cannot be effectively increased.

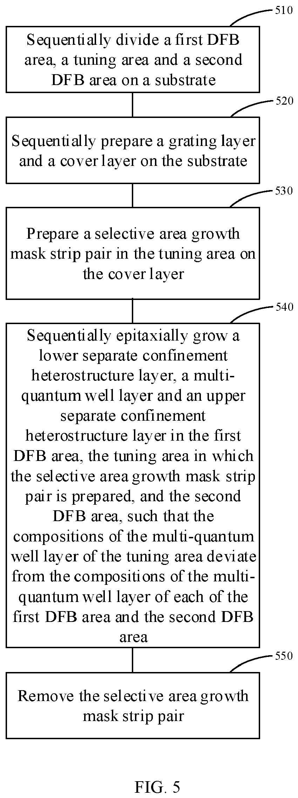

Referring to Fig. 5, in an embodiment, the manufacturing method for a laser according to the embodiment in Fig. 4 is expanded, and includes, but not limited to, following steps S510 to S550.

At S510, a first DFB area, a tuning area and a second DFB area are sequentially divided on a substrate.

At S520, a grating layer and a cover layer are sequentially prepared on the substrate.

At S530, a selective area growth mask strip pair is prepared in the tuning area on the cover layer.

At S540, a lower separate confinement heterostructure layer, a multi-quantum well layer and an upper separate confinement heterostructure layer are sequentially epitaxially grown in the first DFB area, the tuning area in which the selective area growth mask strip pair is prepared, and the second DFB area, such that the compositions of the multi-quantum well layer of the tuning area deviate from the compositions of the multi-quantum well layer of each of the first DFB area and the second DFB area.

At S550, the selective area growth mask strip pair is removed.

In an embodiment, with the above steps S510 to S550, a first DFB area, a tuning area and a second DFB area are sequentially divided on an epitaxially grown plane of a substrate; a grating layer and a cover layer are sequentially prepared on the substrate; a selective area growth mask strip pair is prepared in the tuning area on the cover layer; after the selective area growth mask strip pair is prepared, a lower separate confinement heterostructure layer, a multi-quantum well layer and an upper separate confinement heterostructure layer are sequentially epitaxially grown in the first DFB area, the tuning area in which the selective area growth mask strip pair is prepared, and the second DFB area; and the selective area growth mask strip pair is removed. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The overall manufacturing method for a laser is simple, only the preparation of the selective area growth mask strip pair is added, and the manufacturing cost of the laser can be well controlled.

It should be noted that a grating of the grating layer may have a period of Λ, and a Bragg lasing wavelength of the laser is expressed as λ=2neffΛ, where neff is an effective refractive index of a waveguide, and A is the period of the grating. The lasing wavelength determined by the period A of the grating and the effective refractive index neff jointly is designed to be at the apex of the gain peak of the active layers of the two DFB areas, so that the gain peak of the active layer of the tuning area has a certain amount of deviation from the Bragg lasing wavelength, thereby increasing the boundary current of the tuning area.

It should be noted that the grating may be prepared by means of holographic exposure or electron beam direct writing, which will not be specifically limited in this embodiment.

It should be noted that the grating may be a uniform grating or a phase shift grating, which will not be not specifically limited in this embodiment.

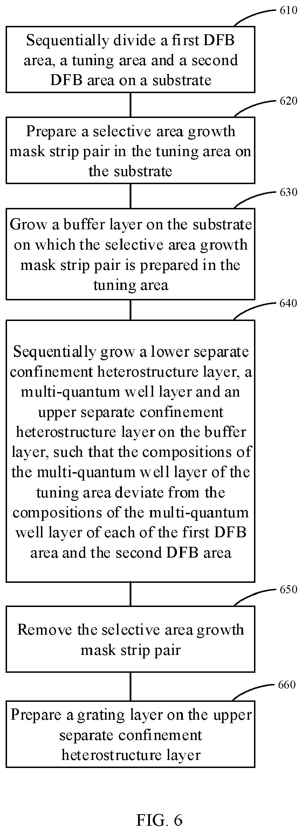

Referring to Fig. 6, in an embodiment, the manufacturing method for a laser according to the embodiment in Fig. 4 is expanded, and includes, but not limited to, following steps S610 to S660.

At S610, a first DFB area, a tuning area and a second DFB area are sequentially divided on a substrate.

At S620, a selective area growth mask strip pair is prepared in the tuning area on the substrate.

At S630, a buffer layer is grown on the substrate on which the selective area growth mask strip pair is prepared in the tuning area.

At S640, a lower separate confinement heterostructure layer, a multi-quantum well layer and an upper separate confinement heterostructure layer are sequentially grown on the buffer layer, such that the compositions of the multi-quantum well layer of the tuning area deviate from the compositions of the multi-quantum well layer of each of the first DFB area and the second DFB area.

At S650, the selective area growth mask strip pair is removed.

At S660, a grating layer is prepared on the upper separate confinement heterostructure layer.

In an embodiment, with the above steps S610 to S660, a first DFB area, a tuning area and a second DFB area are sequentially divided on an epitaxially grown plane of a substrate; a selective area growth mask strip pair is prepared in the tuning area on the substrate; after the selective area growth mask strip pair is prepared, a buffer layer, a lower separate confinement heterostructure layer, a multi-quantum well layer and an upper separate confinement heterostructure layer are sequentially epitaxially grown in the first DFB area, the tuning area and the second DFB area on the substrate on which the selective area growth mask strip pair is prepared in the tuning area; the selective area growth mask strip pair is removed; and a grating is prepared on the upper separate confinement heterostructure layer. Due to the effect of the selective area growth mask strip pair, growth source molecules have different nucleation characteristics on different material surfaces during epitaxial growth, such that material compositions of the area corresponding to the selective area growth mask strip pair are changed, and a material lasing wavelength of the area corresponding to the selective area growth mask strip pair is red-shifted relative to an area not corresponding to the selective area growth mask strip pair. Therefore, only one epitaxial growth is needed to realize the deviation of band gap wavelengths of active layers of the tuning area and the DFB areas, thereby realizing that a boundary current of the tuning area is greater than a threshold current of the DFB areas, and thus increasing a wavelength tuning range of the laser. Through a reasonable design of the stripe width, spacing and shape of the selective area growth mask stripe pair, an amount of deviation of band gap wavelengths can be controlled, and a smooth transition between the active layers of the DFB areas and the active layer of the tuning area can be ensured without causing interface defects that may bring reliability problems. The overall manufacturing method for a laser is simple, only the preparation of the selective area growth mask strip pair is added, and the manufacturing cost of the laser can be well controlled.

It should be noted that a grating of the grating layer may have a period of Λ, and a Bragg lasing wavelength of the laser is expressed as λ=2neffΛ, where neff is an effective refractive index of a waveguide, and A is the period of the grating. The lasing wavelength determined by the period A of the grating and the effective refractive index neff jointly is designed to be at the apex of the gain peak of the active layers of the two DFB areas, so that the gain peak of the active layer of the tuning area has a certain amount of deviation from the Bragg lasing wavelength, thereby increasing the boundary current of the tuning area.

It should be noted that the grating may be prepared by means of holographic exposure or electron beam direct writing, which will not be specifically limited in this embodiment.

It should be noted that the grating may be a uniform grating or a phase shift grating, which will not be specifically limited in this embodiment.

The manufacturing method for a laser according to the above embodiment is illustrated in detail as follows.

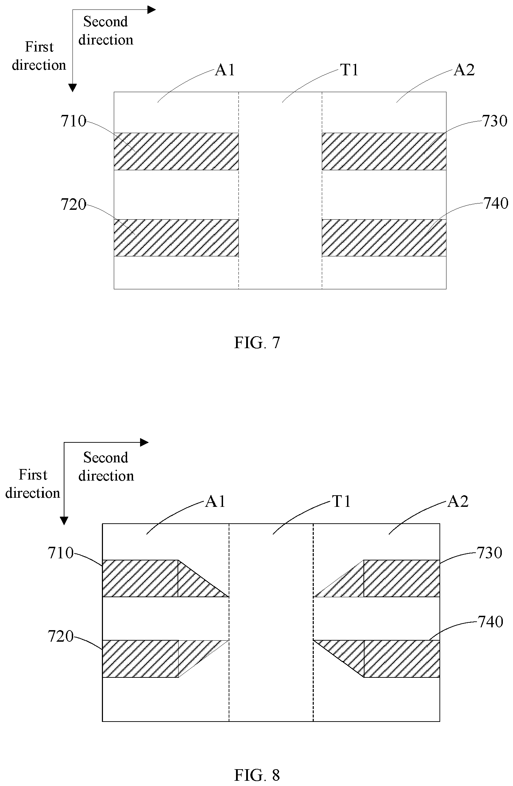

Embodiment one: as shown in Fig. 7 which is a top view of a laser, in an embodiment, the laser may be divided into three areas (including a first DFB area A1, a second DFB area A2 and a tuning area T1). The first DFB area A1 and the second DFB area A2 may be separately set at two sides of the laser, and the tuning area T1 may be set between the first DFB area A1 and the second DFB area A2. A selective area growth mask strip pair may be prepared in each of the first DFB area A1 and the second DFB area A2 on the substrate 910, and the selective area growth mask strip pair includes a first selective area growth mask strip pair and a second selective area growth mask strip pair. The first selective area growth mask strip pair includes a first dielectric mask strip 710 and a second dielectric mask strip 720 which are prepared in a first direction. The second selective area growth mask strip pair is prepared in the second DFB area and includes a third dielectric mask strip 730 and a fourth dielectric mask strip 740 which are prepared in the first direction. The first selective area growth mask strip pair and the second selective area growth mask strip pair are prepared in a second direction perpendicular to the first direction. When manufacturing the laser, active layers (including a lower separate confinement heterostructure layer 930, a multi-quantum well layer 940 and an upper separate confinement heterostructure layer 950) may be epitaxially grown in the first DFB area A1, the tuning area T1 and the second DFB area A2 on the substrate on which the selective area growth mask strip pair is prepared. Through a reasonable preparation of the selective area growth mask stripe pair, an amount of deviation of band gap wavelengths can be controlled, and a smooth transition between the active layers of the DFB areas and the active layer of the tuning area T1 can be ensured without causing interface defects that may bring reliability problems. The overall manufacturing method for a semiconductor laser is simple, only the preparation of the selective area growth mask strip pair is added, and the manufacturing cost of the laser can be well controlled.

It should be noted that the first dielectric mask strip 710 and the third dielectric mask strip 730 may be prepared in mirror symmetry, and the second dielectric mask strip 720 and the fourth dielectric mask strip 740 may be prepared in mirror symmetry.

It should be noted that referring to Fig. 8, an end of each of the first dielectric mask strip 710, the second dielectric mask strip 720, the third dielectric mask strip 730 and the fourth dielectric mask strip 740 close to the tuning area may be prepared in a gradually narrowed shape. Thus, after performing one epitaxial growth on the selective area growth mask stripe pair, a further smooth transition at an interface between the first DFB area A1 and the tuning area T1, and at an interface between the second DFB area A2 and the tuning area T1 can be enabled, which can better reduce the occurrence of interface defects and reduce the reliability problems caused by the interface defects.

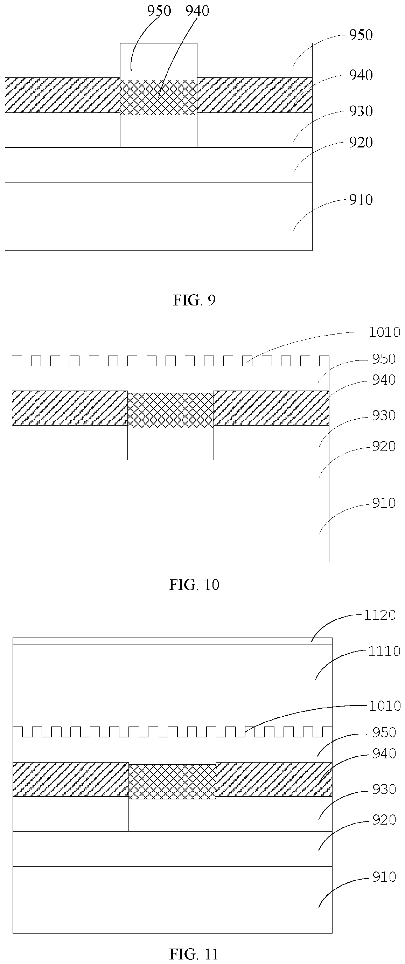

Referring to Fig. 9, based on the above structure shown in Fig. 7, in an embodiment, after preparing a selective area growth mask stripe pair in each of the first DFB area A1 and the second DFB area A2 on the substrate 910, an epitaxial wafer is cleaned, first epitaxial growth can be performed in a Metal-organic Chemical Vapor Deposition (MOCVD) device, and a buffer layer 920, a lower separate confinement heterostructure layer 930, a multi-quantum well layer 940 and an upper separate confinement heterostructure layer 950 are sequentially epitaxially grown on the substrate 910 on which the selective area growth mask strip pair is prepared. The substrate 910 may be made of Indium Phosphide (InP), the separate confinement heterostructure layers (including the lower separate confinement heterostructure layer 930 and the upper separate confinement heterostructure layer 950), and the multi-quantum well layer 940 may be made of InGaAsP quaternary material. Due to the effect of the dielectric mask strips, the wavelength of the InGaAsP quaternary material in a growth window where the selective area growth mask strip is located is red-shifted due to a combined effect of thickness enhancement and indium enrichment, that is, the wavelength of spontaneous radiation of the material in the area affected by the selective area growth mask strip pair is greater than that in the large area. In the structure in this embodiment, the wavelength of spontaneous radiation of the first DFB area A1 and the second DFB area A2 is greater than that of the intermediate tuning area. When the Bragg lasing wavelength of the laser corresponds to the PhotoLuminescence (PL) peak wavelength of the DFB area material, the PL peak wavelength of the tuning area inevitably has a certain amount of deviation from the Bragg lasing wavelength, so that a boundary current of the active layer of the tuning area T1 is greater than a threshold current of each active layer of the first DFB area A1 and the second DFB area A2, thereby increasing a tuning range of the laser. An amount of deviation of the band gap wavelengths of the active layers of the first DFB area A1 and the second DFB area A2 from the band gap wavelength of the active layer of the tuning area T1 is determined by the size of a pattern of a dielectric mask strip (including the spacing and width of the dielectric mask strip). Through a reasonable design of the size of the dielectric mask strip pair, the amount of deviation of the band gap wavelengths of the first DFB area A1, the second DFB area A2 and the tuning area T1 can be controlled between 30 nm and 80 nm. If the amount of deviation of band gap wavelengths is too large, the material growth quality will be affected, and the transition interface will not be smooth enough, affecting the reliability of the device; and if the amount of deviation of the band gap wavelengths is too small, the amount of deviation of a Bragg lasing wavelength from a PL peak wavelength of the tuning area is too small, and a difference between the boundary current of the active layer of the tuning area and the threshold current of the active layers of the two DFB areas is small, thus the tuning range of the laser cannot be effectively increased.

As shown in Fig. 10, after epitaxial growth, a grating 1010 with a period of A is prepared on the upper separate confinement heterostructure layer 950, and a Bragg lasing wavelength of the laser may be expressed as λ=2neffΛ, where neff is an effective refractive index of a waveguide, and A is the period of the grating 1010. The lasing wavelength determined by the period of the grating 1010 and the effective refractive index jointly is designed to be at the apex of the gain peak of the active layers of the first DFB area A1 and the second DFB area A2, so that the gain peak of the active layer of the tuning area T1 has a certain amount of deviation from the Bragg lasing wavelength, thereby increasing the boundary current of the tuning area.

It should be noted that the grating may be directly prepared on the upper separate confinement heterostructure layer, or a grating layer is grown on the upper separate confinement heterostructure layer and a grating is prepared on the grating layer, which will not be specifically limited in this embodiment.

As shown in Fig. 11, after the grating 1010 is prepared, a P-type cover layer 1110 and a contact layer 1120 can be continuously epitaxially grown. Then, according to the process flow of a general laser, a waveguide structure is prepared, and an insulating dielectric layer is grown. A P-plane metal can be prepared after a window is opened.

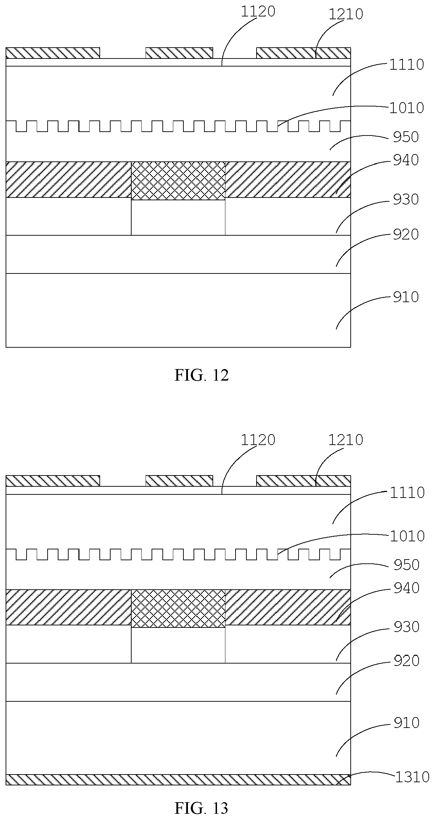

As shown in Fig. 12, the first DFB area A1, the second DFB area A2 and the tuning area T1 are each provided with an electrode 1210, and heavily-doped contact layers among the three areas are etched away to achieve electrical isolation from one another. During operation, the electrodes 1210 of the first DFB area A1 and the second DFB area A2 may be connected and loaded with a bias current, and the electrode 1210 above the tuning area T1 may be loaded with a tuning current alone. A chip of the laser is thinned, as shown in Fig. 13, an N-plane electrode 1310 may be prepared below the substrate 910, to complete the preparation of the whole laser.

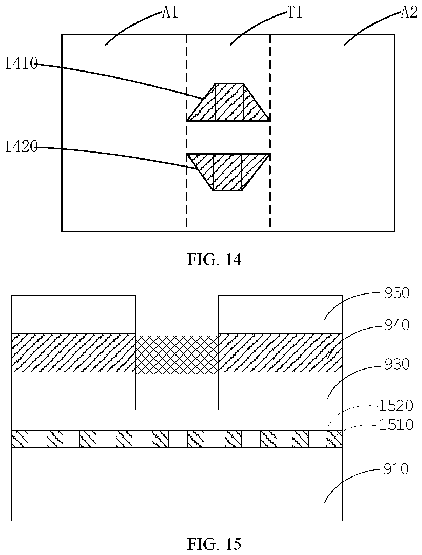

Embodiment two: as shown in Fig. 14, a selective area growth mask strip pair 1410 may also be prepared in the intermediate tuning area, as shown in Fig. 10. In this case, during epitaxial growth, the number, thickness and composition parameters of wells in the multi-quantum well layer 940 are grown according to the requirements of the material structure of the DFB laser in the non-large area (the first DFB area A1 and the second DFB area A2). Due to the combined effect of thickness increase of the dielectric mask strip and indium enrichment, the material compositions in the tuning area of the multi-quantum well layer 940 are different from the compositions in the first DFB area A1 and the second DFB area A2 of the multi-quantum well layer 940, and the wavelength of spontaneous radiation in the tuning area is greater than that in the DFB areas. When the Bragg lasing wavelength is designed at the apex of the PL peak of the active layers of the DFB areas, the apex of the PL peak of the active layer of the wavelength tuning area has a certain amount of deviation from the lasing wavelength, which can also achieve the object that the boundary current of the active layer of the tuning area is greater than the threshold current of the active layers of the DFB areas. The remaining growth and preparation steps are the same as those in embodiment one, which will not be repeated here. Through a reasonable preparation of the selective area growth mask stripe pair 1410, the amount of deviation of band gap wavelengths can be controlled, and a smooth transition between the active layers of the DFB areas and the active layer of the tuning area T1 can be ensured without causing interface defects that may bring reliability problems. The overall manufacturing method for a semiconductor laser is simple, only the preparation of the selective area growth mask strip pair is added, and the manufacturing cost of the laser can be well controlled.

Embodiment three: as shown in Fig. 15, a selective area growth mask stripe pair may be prepared in each of the first DFB area A1 and the second DFB area A2, the grating may be prepared as an N-plane grating 1510, and the N-plane grating 1510 may be prepared below the active layer. The manufacturing method for a laser may include following steps: dividing the laser into three areas (including a first DFB area A1, a second DFB area A2 and a tuning area T1), setting the first DFB area A1 and the second DFB area A2 separately at two sides of the laser, setting the tuning area T1 between the first DFB area A1 and the second DFB area A2, growing a grating layer and an InP cover layer on the substrate 910, preparing an N-plane grating 1510 with a specific period, preparing a selective area growth mask stripe pair in each of the first DFB area A1 and the second DFB area A2 of an epitaxial wafer on which the N-plane grating 1510 is prepared, and sequentially epitaxially growing a lower separate confinement heterostructure layer 930, a multi-quantum well layer 940, an upper separate confinement heterostructure layer 950, a P-type InP cover layer and a heavily-doped contact layer. The remaining growth and preparation steps are the same as those in embodiment one, which will not be repeated here. Through a reasonable preparation of the selective area growth mask stripe pair, the amount of deviation of band gap wavelengths can be controlled, and a smooth transition between the active layers of the DFB areas and the active layer of the tuning area T1 can be ensured without causing interface defects that may bring reliability problems. The overall manufacturing method for a semiconductor laser is simple, only the preparation of the selective area growth mask strip pair is added, and the manufacturing cost of the laser can be well controlled.

Embodiment four: a selective area growth mask stripe pair may be prepared in the tuning area T1, and the grating may be prepared as an N-plane grating 1510. In the manufacturing method for a laser in this embodiment, the N-plane grating 1510 is prepared below the active layer, (which is the same as the manufacturing method for a laser with an N-plane grating 1510 in embodiment three, and will not be repeated here), and the selective area growth mask strip pair is prepared in the intermediate tuning area (which is the same as the manufacturing method for a laser with a selective area growth mask strip pair in embodiment two, and will not be repeated here). The remaining epitaxial growth and device manufacturing methods are the same as those in embodiment one, which will not be repeated here. Through a reasonable preparation of the selective area growth mask stripe pair, the amount of deviation of band gap wavelengths can be controlled, and a smooth transition between the active layers of the DFB areas and the active layer of tuning area T1 can be ensured without causing interface defects that may bring reliability problems. The overall manufacturing method for a semiconductor laser is simple, only the preparation of the selective area growth mask strip pair is added, and the manufacturing cost of the laser can be well controlled.

Another embodiment of the present disclosure further provides a laser, which is manufactured by means of the manufacturing method provided in the above embodiment. Through a reasonable design of the stripe width, spacing and shape of a selective area growth mask stripe pair, the amount of deviation of band gap wavelengths can be controlled, and a smooth transition between the active layers of the DFB areas and the active layer of the tuning area can be ensured without causing interface defects that may bring reliability problems. The overall manufacturing method for a semiconductor laser is simple, only the preparation of the selective area growth mask strip pair is added, and the manufacturing cost of the laser can be well controlled.

Embodiments of the present disclosure provide a manufacturing method for a laser and a laser. The manufacturing method for a laser includes: sequentially dividing a first DFB area, a tuning area and a second DFB area on a substrate; preparing a selective area growth mask strip pair in each of the first DFB area and the second DFB area, or preparing a selective area growth mask strip pair in the tuning area; sequentially epitaxially growing a lower separate confinement heterostructure layer, a multi-quantum well layer and an upper separate confinement heterostructure layer in the first DFB area in which the selective area growth mask strip pair is prepared, the tuning area, and the second DFB area in which the selective area growth mask strip pair is prepared, or in the first DFB area, the tuning area in which the selective area growth mask strip pair is prepared, and the second DFB area, such that the compositions of the multi-quantum well layer of the tuning area deviate from the compositions of the multi-quantum well layer of each of the first DFB area and the second DFB area; and removing the selective area growth mask strip pair. In the manufacturing method, the laser is divided into a first DFB area, a tuning area and a second DFB area; a selective area growth mask strip pair is prepared before the lower separate confinement heterostructure layer is grown, such that the compositions of the multi-quantum well layer of the tuning area deviate from the compositions of the multi-quantum well layer of each of the first DFB area and the second DFB area; and the selective area growth mask strip pair is removed after the upper separate confinement heterostructure layer is grown. The laser manufactured by means of the manufacturing method has high reliability and an increased wavelength tuning range.

Those having ordinary skills in the art can understand that all or some of the steps, and systems in the method disclosed above may be implemented as software, firmware, hardware and appropriate combinations thereof. Some or all of the physical components may be implemented as software executed by a processor, such as a central processing unit, a digital signal processor or a microprocessor, or as hardware, or as an integrated circuit, such as an application specific integrated circuit. Such software may be distributed on a computer-readable medium, and the computer-readable medium may include a computer storage medium (or a non-transitory medium) and a communication medium (or a transitory medium). As is well known to those having ordinary skills in the art, the term computer storage medium includes volatile and nonvolatile, removable and non-removable media implemented in any method or technology for storing information such as computer readable instructions, data structures, program modules or other data. A computer storage medium may include RAM, ROM, EEPROM, flash memory or other memory technologies, CD-ROM, digital versatile disk (DVD) or other optical disk storage, magnetic cassette, magnetic tape, magnetic disk storage or other magnetic storage devices, or any other media that can be used to store desired information and can be accessed by a computer. In addition, it is well known to those having ordinary skills in the art that the communication medium may generally include computer readable instructions, data structures, program modules or other data in a modulated data signal such as a carrier wave or other transmission mechanism, and may include any information delivery medium.

The above is a detailed description of some embodiments of the present disclosure, but the present disclosure is not limited thereto. Those having ordinary skills in this field can also make various equivalent modifications or substitutions without violating the scope of this application, and these equivalent modifications or substitutions are all included in the scope defined by the claims of the present disclosure

## Claims

1. A manufacturing method for a laser, comprising:
sequentially dividing a first Distributed Feedback, DFB, area, a tuning area and a second DFB area on a substrate;
preparing a selective area growth mask strip pair in each of the first DFB area and the second DFB area;
sequentially epitaxially growing a lower separate confinement heterostructure layer, a multi-quantum well layer and an upper separate confinement heterostructure layer in the first DFB area in which the selective area growth mask strip pair is prepared, the tuning area, and the second DFB area in which the selective area growth mask strip pair is prepared, such that the compositions of the multi-quantum well layer of the tuning area deviate from the compositions of the multi-quantum well layer of each of the first DFB area and the second DFB area; and
removing the selective area growth mask strip pair.

2. The manufacturing method for a laser of claim 1, wherein preparing a selective area growth mask strip pair in each of the first DFB area and the second DFB area comprises:
preparing a first selective area growth mask strip pair in the first DFB area, the first selective area growth mask strip pair comprising a first selective area growth mask strip and a second selective area growth mask strip which are sequentially arranged in a first direction;
preparing a second selective area growth mask strip pair in the second DFB area, the second selective area growth mask strip pair comprising a third selective area growth mask strip and a fourth selective area growth mask strip which are sequentially arranged in the first direction; and
preparing the first selective area growth mask strip pair and the second selective area growth mask strip pair in a second direction perpendicular to the first direction.

3. The manufacturing method for a laser of claim 2, wherein preparing a selective area growth mask strip pair in each of the first DFB area and the second DFB area further comprises:
arranging the first selective area growth mask strip and the third selective area growth mask strip in mirror symmetry; and
arranging the second selective area growth mask strip and the fourth selective area growth mask strip in mirror symmetry.

4. The manufacturing method for a laser of claim 3, wherein preparing a selective area growth mask strip pair in each of the first DFB area and the second DFB area further comprises:
preparing an end of each of the first selective area growth mask strip, the second selective area growth mask strip, the third selective area growth mask strip and the fourth selective area growth mask strip close to the tuning area in a gradually narrowed shape.

5. The manufacturing method for a laser of claim 1, wherein after sequentially dividing a first DFB area, a tuning area and a second DFB area on a substrate, the method further comprises sequentially preparing a grating layer and a cover layer on the substrate.

6. The manufacturing method for a laser of claim 5, wherein preparing a selective area growth mask strip pair in each of the first DFB area and the second DFB area comprises:
preparing a selective area growth mask strip pair in each of the first DFB area and the second DFB area on the cover layer.

7. The manufacturing method for a laser of claim 1, wherein after removing the selective area growth mask strip pair, the method further comprises preparing a grating layer on the upper separate confinement heterostructure layer.

8. A manufacturing method for a laser, comprising:
sequentially dividing a first DFB area, a tuning area and a second DFB area on a substrate;
preparing a selective area growth mask strip pair in the tuning area;
sequentially epitaxially growing a lower separate confinement heterostructure layer, a multi-quantum well layer and an upper separate confinement heterostructure layer in the first DFB area, the tuning area in which the selective area growth mask strip pair is prepared and the second DFB area, such that the compositions of the multi-quantum well layer of the tuning area deviate from the compositions of the multi-quantum well layer of each of the first DFB area and the second DFB area; and
removing the selective area growth mask strip pair.

9. The manufacturing method for a laser of claim 8, wherein sequentially epitaxially growing a lower separate confinement heterostructure layer, a multi-quantum well layer and an upper separate confinement heterostructure layer in the first DFB area, the tuning area in which the selective area growth mask strip pair is prepared and the second DFB area comprises:
growing a buffer layer on the substrate on which the selective area growth mask strip pair is prepared in the tuning area; and
sequentially growing a lower separate confinement heterostructure layer, a multi-quantum well layer and an upper separate confinement heterostructure layer on the buffer layer.

10. The manufacturing method for a laser of claim 8, wherein preparing a selective area growth mask strip pair in the tuning area comprises:
preparing an end of the selective area growth mask strip pair close to the first DFB area in a gradually narrowed shape; and
preparing an end of the selective area growth mask strip pair close to the second DFB area in a gradually narrowed shape.

11. The manufacturing method for a laser of claim 8, wherein after sequentially dividing a first DFB area, a tuning area and a second DFB area on a substrate, the method further comprises sequentially preparing a grating layer and a cover layer on the substrate.

12. The manufacturing method for a laser of claim 11, wherein preparing a selective area growth mask strip pair in the tuning area comprises:
preparing a selective area growth mask strip pair in the tuning area on the cover layer.

13. The manufacturing method for a laser of claim 8, wherein after removing the selective area growth mask strip pair, the method further comprises preparing a grating layer on the upper separate confinement heterostructure layer.

14. A laser manufactured by means of the manufacturing method of any one of claims 1 to 7; or manufactured by means of the manufacturing method of any one of claims 8 to 13.
